# EUROPÄISCHE PATENTSCHRIFT

(11) **EP 2 916 393 B1**
(45) Veröffentlichungstag und Bekanntmachung des Hinweises auf die Patenterteilung: **15.05.2019**
(21) Anmeldenummer: 15157792.1
(22) Anmeldetag: 05.03.2015
(51) Int. Cl.: H01R 12/73, H01R 13/703, F21V 21/005, F21V 23/06, F21S 4/24, H05K 1/14, H01R 12/79

(54) **System mit elektrischen Einheiten**
System with electrical units
Système doté d'unités électriques

(30) Priorität: 07.03.2014 DE 202014101012 U
(43) Veröffentlichungstag der Anmeldung: 09.09.2015
(73) Patentinhaber: Zumtobel Lighting GmbH, 6850 Dornbirn (AT)
(72) Erfinder: Osl, Lukas, 6900 Bregenz (AT); Machate, Andreas, 88239 Wangen im Allgäu (DE)
(74) Vertreter: Thun, Clemens

(56) Entgegenhaltungen:
- EP-A1- 2 285 195
- EP-A1- 2 530 794
- EP-A2- 0 253 645
- EP-A2- 2 166 273
- JP-A- 2013 004 189
- US-A1- 2009 244 871
- US-A1- 2010 259 928

## Beschreibung

Die Erfindung betrifft ein System mit elektrischen Einheiten mit elektrischen Verbindungsmittel zum Anschließen eines elektrischen Verbrauchers an eine elektrische Leiterbahn.

Aus dem Stand der Technik ist es bekannt, zwei länglichen Platinen mit darauf angeordneten elektrischen Verbrauchern in Form von LEDs (LED: Licht emittierende Diode) in einer Reihe hintereinander anzuordnen und elektrisch so zu verbinden, dass die auf den beiden Platinen angeordneten LEDs in Reihe geschaltet sind. Bevor die beiden LED-Platinen elektrisch miteinander verbunden werden, weisen sie jeweils eine Leiterbahn auf, durch die die betreffenden LEDs miteinander in Reihe geschaltet sind. Zum Verbinden der Platinen müssen diese beiden Leiterbahnen dementsprechend aufwändig modifiziert und verbunden werden, beispielsweise mithilfe von Löt-Arbeiten.

Aus der EP 2 530 794 A1 sind elektrische Verbindungsmittel bekannt, die eine Buchse und einen Stecker aufweisen. Beim Einstecken des Steckers in die Buchse werden die beiden Buchsen-seitigen Leiterbahnenden durch ein keilförmiges Trennelement elektrisch voneinander getrennt und mit Stecker-seitigen Leiterbahnenden verbunden.

Aus der JP 2013-004189 A ist ein LED-Beleuchtungssystem bekannt, bei dem LED-Platinen mittels Steckern und Buchsen miteinander verbunden werden.

Aus der EP 2 166 273 A2 ist ein System mit zwei LED-Leuchtmodulen bekannt, die sich über einen Stecker und eine Buchse miteinander elektrisch verbinden lassen. Dabei ist die Steckverbindung so gestaltet, dass eine, an dem ersten LED-Leuchtmodul ausgebildete Leiterbahn unterbrochen wird und die so gebildeten Endstücke an eine auf dem zweiten LED-Leuchtmodul gebildete Leiterbahn angeschlossen werden, wenn der Stecker in die Buchse gesteckt wird.

Aus der EP 2 285 195 A1 ist ein System mit zwei LED-Leuchtmodulen bekannt, die über eine Buchsen-Stecker-Anordnung elektrisch miteinander verbunden werden können.

Der Erfindung liegt die Aufgabe zugrunde, ein System zum Herstellen einer Leiterbahn mit einem darin seriell geschalteten Verbraucher anzugeben.

Diese Aufgabe wird gemäß der Erfindung mit dem in dem unabhängigen Anspruch 1 genannten Gegenstand gelöst. Besondere Ausführungsarten der Erfindung sind in den abhängigen Ansprüchen angegeben.

Gemäß der Erfindung ist ein System nach Anspruch 1 mit einer ersten Einheit und einer zweiten Einheit vorgesehen, wobei die erste Einheit eine erste elektrische Leiterbahn aufweist und die zweite Einheit einen elektrischen Verbraucher. Weiterhin weist das System Verbindungsmittel zum Anschließen des Verbrauchers an die erste Leiterbahn auf, wobei die Verbindungsmittel eine Buchse und einen, reversibel lösbar in die Buchse einsteckbaren Stecker aufweisen; dabei sind die Verbindungsmittel derart ausgestaltet, dass bei einem Einstecken des Steckers in die Buchse die erste Leiterbahn unterbrochen wird und der Verbraucher an die beiden, durch diese Unterbrechung gebildeten Endstücke der ersten Leiterbahn elektrisch angeschlossen wird.

Durch diese Ausgestaltung des Systems lässt sich erzielen, dass sich der Verbraucher durch die Verbindungsmittel besonders handhabungsfreundlich und einfach seriell in die Leiterbahn schalten lässt.

Vorzugsweise ist der Verbraucher durch eine LED-Lichtquelle gebildet. Dabei sei mit LED-Lichtquelle eine Lichtquelle bezeichnet, die wenigstens eine LED umfasst. Ein entsprechendes Anschließen einer derartigen LED-Lichtquelle ermöglicht die Bildung einer seriellen Anordnung der LED-Lichtquelle in der Leiterbahn. Dies ist besonders vorteilheft, weil hierdurch die LED-Lichtquelle besonders geeignet zur Stromversorgung mit einer Konstantstrom-Quelle verbunden werden kann.

Erfindungsgemäß weist die erste Einheit eine erste Platine mit LEDs auf, die in die erste Leiterbahn geschaltet sind und die zweite Einheit eine zweite elektrische Leiterbahn, sowie eine zweite Platine mit LEDs, die in die zweite Leiterbahn geschaltet sind, wobei der Verbraucher durch die LEDs der zweiten Platine gegeben ist. Hierdurch lassen sich die LEDs der ersten Platine und die LEDs der zweiten Platine besonders einfach elektrisch in Reihe schalten.

Vorzugsweise sind die LEDs der ersten Patine durch eine erste Leiterbahn in Reihe geschaltet miteinander verbunden und die LEDs der zweiten Platine durch eine zweite Leiterbahn in Reihe geschaltet miteinander verbunden, wobei die Gestaltung derart ist, dass die LEDs der ersten Platine und die LEDs der zweiten Platine elektrisch in einer Reihe miteinander verbunden sind, wenn der Stecker in die Buchse eingesteckt ist.

Dabei ist weiterhin vorzugsweise die Buchse an der ersten Platine angeordnet, insbesondere kann sie lagefest oder verschiebbar an der ersten Platine angeordnet sein. Hierdurch ist eine besonders einfache Handhabung beim Verbinden der zwei Platinen ermöglicht.

Vorzugsweise ist die Buchse durch eine reversibel lösbare Steckverbindung mit der ersten Platine verbunden. Auf diese Weise lässt sich die Buchse, wenn sie nicht benötigt wird, besonders einfach von der ersten Platine entfernen und bei Bedarf auch wieder mit Letzterer verbinden.

Vorzugsweise weist die erste Patine eine Durchgangsöffnung auf, wobei die Gestaltung derart ist, dass der Stecker die Durchgangsöffnung durchsetzend angeordnet ist, wenn der Stecker in die Buchse eingesteckt ist. Auf diese Weise ist die Möglichkeit eröffnet, den Stecker von einer, der Buchse gegenüber liegenden Seite der Platine her einzustecken.

Vorzugsweise ist der Stecker an der zweiten Platine angeordnet, insbesondere lagefest oder verschiebbar an der zweiten Platine angeordnet. Dabei ist weiterhin vorzugsweise der Stecker durch eine reversibel lösbare Steckverbindung mit der zweiten Platine verbunden. Hierdurch lässt sich der Stecker leicht von der zweiten Platine separieren, wenn er nicht gebraucht wird. Dies kann zum Beispiel im Fall von mehreren Platinen zur Bildung eines Lichtbands bei der letzten Platine der Reihe erwünscht sein, um ein Überstehen des entsprechenden Steckers zu vermeiden.

Die Erfindung wird im Folgenden anhand eines Ausführungsbeispiels und mit Bezug auf die Zeichnungen näher erläutert. Es zeigen:
- Fig. 1: eine perspektivische Skizze zu einer möglichen Ausführungsform eines erfindungsgemäßen Systems,
- Fig. 2: eine Querschnitt-Skizze zu den Verbindungsmitteln des Systems,
- Fig. 3: eine schematische Skizze zur Ausführung einer Buchse der Verbindungsmittel und
- Fig. 4: eine Skizze zu einer weiteren möglichen Ausführungsform des erfindungsgemäßen Systems.

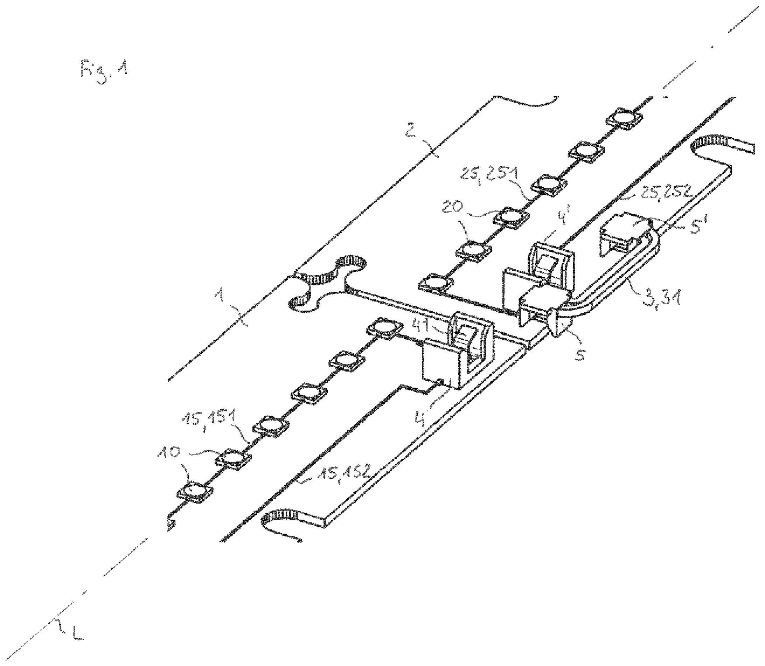

Fig. 1 zeigt eine perspektivische Skizze zu einem ersten Ausführungsbeispiel eines erfindungsgemäßen Systems mit erfindungsgemäßen Verbindungsmitteln 3. Das System weist eine erste Einheit mit einer ersten elektrischen Leiterbahn 15 auf; im gezeigten Beispiel umfasst die erste Einheit eine erste Platine 1 mit LEDs 10, die in die erste Leiterbahn 15 geschaltet sind.

Weiterhin weist das System eine zweite Einheit mit einem elektrischen Verbraucher auf; im gezeigten Beispiel umfasst die zweite Einheit eine zweite Platine 2 mit LEDs 20, die in die zweite Leiterbahn 25 geschaltet sind, wobei der Verbraucher durch die LEDs 20 der zweiten Platine 2 gegeben ist.

Die LEDs 10 der ersten Platine 1 sind beispielswiese in Reihe geschaltet. Auch die LEDs 20 der zweiten Platine 2 können in Reihe geschaltet sein.

Die Platinen 1, 2 können jeweils länglich geformt sein; beispielsweise kann vorgesehen sein, dass die Platinen 1, 2 eine Lichtquelle eines Lichtbands bilden, wobei sie entlang einer Längsachse L ausgerichtet angeordnet sind. Dementsprechend weist die erste Platine 1 mit Bezug auf die Längsachse L einen, in Fig. 1 skizzierten, ersten Endbereich auf, sowie einen entsprechenden, in Fig. 1 nicht gezeigten, zweiten Endbereich. Analoges gilt für die zweite Platine 2.

Insbesondere können mehr als zwei entsprechende Platinen in einer entlang der Längsachse L gebildeten Reihe vorgesehen sein, wobei die mehr als zwei Platinen analog zu den beiden, hier näher beschriebenen Platinen 1, 2 gestaltet sind.

Beim gezeigten Ausführungsbeispiel sind die LEDs 10 der ersten Platine 1 so angeordnet, dass sie eine Reihe bilden, die sich entlang der Längsachse L erstreckt. Die erste Leiterbahn 15 weist dementsprechend einen ersten Ast 151 auf, der sich ebenfalls entlang der Längsachse L erstreckt und der die LEDs 10 der ersten Platine 1 elektrisch miteinander verbindet. Weiterhin umfasst die erste Leiterbahn 15 vorzugsweise einen zweiten Ast 152, der sich ebenfalls entlang der Längsachse L erstreckt. Durch diese Gestaltung eignet sich die erste Platine 1 als solche, also insbesondere ohne mit der zweiten Platine 2 verbunden zu sein, als Lichtquelle einer Leuchte, wobei die LEDs 10 der ersten Platine 1 durch die erste Leiterbahn 15 in einer Reihe geschaltet sind. Hierzu kann die erste Leiterbahn 15 an dem, in Fig. 1 nicht gezeigten zweiten Endbereich der ersten Platine 1 entsprechend mit einer Stromquelle bzw. einem Betriebsgerät zur Stromversorgung der LEDs 10 verbunden sein. Bei der Stromquelle handelt es sich vorzugsweise um eine Konstantstrom-Quelle, da sich in Reihe geschaltet LEDs besonders geeignet mit konstantem Strom betreiben lassen; hierdurch sind besonders konstante Lichtabgabeeigenschaften erzielbar. Insbesondere kann hierzu der erste Ast 151 mit einem ersten Pol der Stromquelle elektrisch verbunden sein und der zweite Ast 152 mit dem entsprechenden zweiten Pol der Stromquelle.

Die Leiterbahn 25 der zweiten Platine 2 weist vorzugsweise ebenfalls einen entsprechenden ersten Ast 251 und einen entsprechenden zweiten Ast 252 auf.

Die Verbindungsmittel 3 umfassen eine Buchse 4 und einen, reversibel lösbar in die Buchse 4 einsteckbaren Stecker 5. Dabei sind die Verbindungsmittel 3 derart ausgestaltet, dass bei einem Einstecken des Steckers 5 in die Buchse 4 die erste Leiterbahn 15 unterbrochen wird und der Verbraucher, hier also die LEDs 20 der zweiten Platine 2, an die beiden, durch diese Unterbrechung gebildeten Endstücke der Leiterbahn 15 elektrisch angeschlossen wird. Auf diese Weise lässt sich allein durch entsprechende Handhabung der Verbindungsmittel 3 der elektrische Verbraucher bzw. die LEDs 20 der zweiten Platine 2 elektrisch in Reihe bzw. seriell in die erste Leiterbahn 15 schalten. Diese Schaltung ist für einen Betrieb der LEDs 20 vorteilhaft, insbesondere weil sie sich für eine Stromversorgung durch eine Konstantstrom-Quelle besonders eignet. Zum Anschließen des Verbrauchers an die erste Leiterbahn 15 ist also quasi lediglich ein Arbeitsgang erforderlich. Es ist dabei auch kein weiteres Bauteil erforderlich.

Vorzugsweise ist die Buchse 4 dabei als Teil der ersten Leiterbahn 15 gestaltet; wie in Fig. 1 skizziert, kann die Buchse 4 dabei insbesondere an dem ersten Endbereich der ersten Platine 1 angeordnet sein bzw. an dem dortigen Übergangsbereich zwischen dem ersten Ast 151 und dem zweiten Ast 152 der ersten Leiterbahn 15.

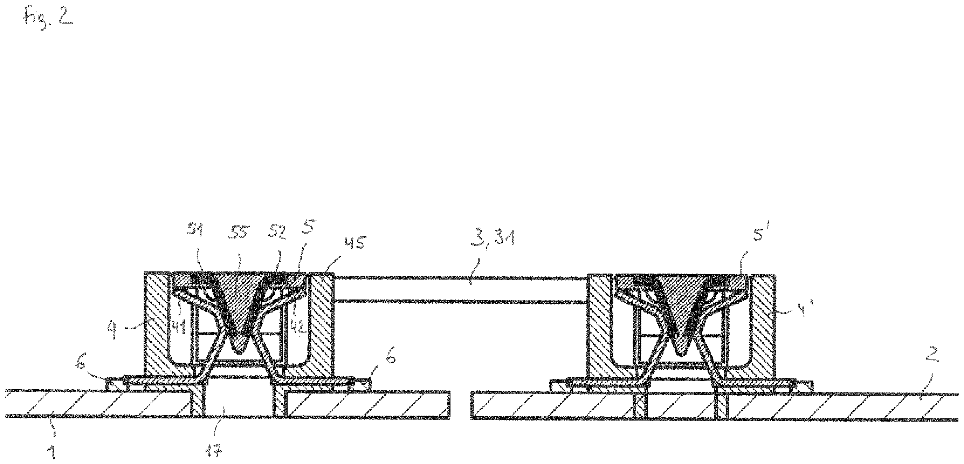

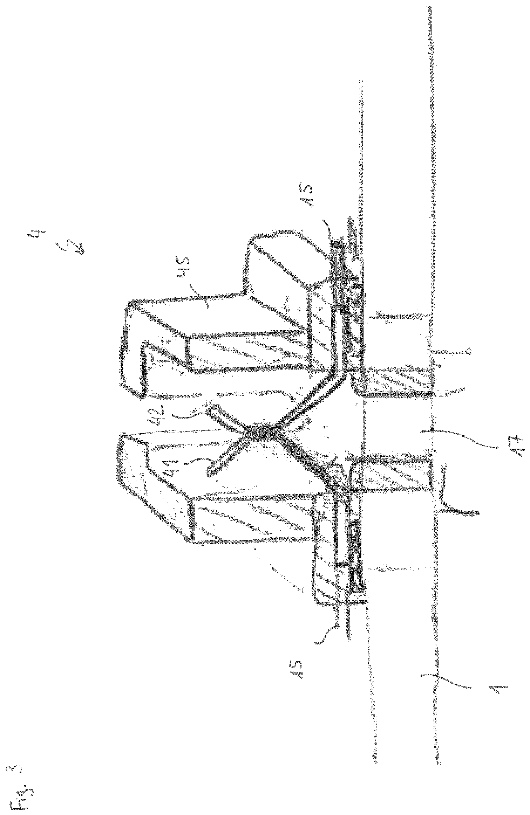

In Fig. 2 ist ein Querschnitt skizziert, der einen möglichen Aufbau der Buchse 4 und des Steckers 5 näher zeigt. Die Buchse 4 weist zwei Kontaktelemente 41, 42 auf, die insbesondere Bestandteile der erste Leiterbahn 15 bilden bzw. in die erste Leiterbahn 15 geschaltet sind, wobei die Verbindungsmittel 3 derart gestaltet sind, dass diese zwei Kontaktelemente 41, 42 der Buchse 4 elektrisch miteinander verbunden sind, wenn der Stecker 5 - wie in Fig. 1 skizziert - nicht in die Buchse 4 eingesteckt ist und die zwei Kontaktelemente 41, 42 der Buchse 4 elektrisch voneinander getrennt sind, wenn der Stecker 5 - wie in Fig. 2 skizziert - in die Buchse 4 eingesteckt ist. Fig. 3 zeigt eine perspektivische schematische Skizze der Buchse 3.

Die zwei Kontaktelemente 41, 42 der Buchse 4 sind vorteilhaft durch Federelemente gebildet, die sich federnd gegenseitig elektrisch kontaktieren, wenn der Stecker 5 nicht in die Buchse 4 eingesteckt ist. Auf diese Weise lässt sich bewirken, dass durch ein Herausziehen des Steckers 5 aus der Buchse 4 die erste Leiterbahn 15 an der Stelle der Buchse 4 ohne Weiteres, also quasi automatisch wieder geschlossen wird.

Wie aus Fig. 2 hervorgeht, weist der Stecker 5 vorzugsweise zwei Kontaktelemente 51, 52 auf, die insbesondere Bestandteile der zweiten Leiterbahn 25 bilden bzw. Bestandteile der zweiten Leiterbahn 25 bilden, wobei die Verbindungsmittel 3 derart gestaltet sind, dass, wenn der Stecker 5 in die Buchse 4 eingesteckt ist, ein erstes Kontaktelement 51 der zwei Kontaktelemente 51, 52 des Steckers 5 ein erstes Kontaktelement 41 der zwei Kontaktelemente 41, 42 der Buchse 4 kontaktiert und das entsprechende zweite Kontaktelement 52 des Steckers 5 das entsprechende zweite Kontaktelement 42 der Buchse 4 kontaktiert.

Wenn der Stecker 5 in die Buchse 4 eingesteckt ist, ist dabei das erste Kontaktelement 41 der Buchse 4 von dem zweiten Kontaktelement 52 des Steckers 5 getrennt und ebenso ist das zweite Kontaktelement 42 der Buchse 4 von dem ersten Kontaktelement 51 des Steckers 5 getrennt. Hierdurch lässt sich durch ein Einstecken des Steckers 5 in die Buchse 4 die erste Leiterbahn 15 sozusagen unterbrechen und dabei insbesondere auf die zweite Leiterbahn 25 "weiterschleusen".

Wie beim gezeigten Beispiel der Fall, kann der Stecker 5 ein insbesondere keilförmiges Trennelement 55 aufweisen, das die zwei Kontaktelemente 41 der Buchse 4 elektrisch voneinander trennend angeordnet ist, wenn der Stecker 5 in die Buchse 4 eingesteckt ist. Dementsprechend ist das Trennelement 55 vorteilhaft aus einem elektrisch nicht leitenden Material gebildet, beispielsweise aus Kunststoff.

Vorzugsweise ist dabei die Keilform derart gestaltet, dass eine Keilspitze des Trennelements 55 in Richtung der Einsteckbewegung des Steckers 5 weist.

Weiterhin vorzugsweise sind dabei die zwei Kontaktelemente 51, 52 des Steckers 5 an dem Trennelement 55 angeordnet, insbesondere unmittelbar an dem Trennelement 55 angeordnet. Mit anderen Worten können die beiden Kontaktelemente 51, 52 des Steckers 5 durch Kontaktflächenelemente gebildet sein, die an Bereichen der Keilflächen des Trennelements 55 angeordnet sind, die in einem gewissen Abstand von der Keilspitze liegen. So lässt sich bewirken, dass während einer ersten Phase des Einsteckens des Steckers 5 in die Buchse 4 die beiden federnden Kontaktelemente 41, 42 von einem Bereich um die Keilspitze des Trennelements 55 voneinander weg gedrückt werden, so dass sie hierdurch räumlich und elektrisch getrennt werden und in einer darauffolgenden zweiten Phase des Einsteckens die beiden Kontaktelemente 51, 52 des Steckers 5, wie oben ausgeführt, entsprechend mit den beiden Kontaktelementen 41, 42 der Buchse 4 elektrisch kontaktiert werden. In der ersten Phase wird also die erste Leiterbahn 15 unterbrochen; in der zweiten Phase wird sozusagen eine "gemeinsame Leiterbahn" erzeugt, in die der Verbraucher seriell geschaltet ist.

Vorzugsweise ist ein mechanischer Anschlag zur Begrenzung der Einsteckbewegung des Steckers 5 ausgebildet, wobei die genannte elektrische Kontaktierung zwischen der Buchse 4 und dem Stecker 5 gebildet ist, wenn der Stecker 5 bis zu dem Anschlag - also sozusagen "ganz" - in die Buchse 4 eingesteckt ist.

Wie in Fig. 1 gezeigt, umfassen beim hier gezeigten Beispiel die Verbindungsmittel 3 vorzugsweise eine weitere Buchse 4', die analog zu der zuerst beschriebenen Buchse 4 ausgestaltet ist, sowie einen entsprechenden weiteren Stecker 5 ', der analog zu dem zuerst genannten Stecker 5 ausgestaltet ist. Die weitere Buchse 4' ist dabei vorzugsweise in analoger Weise in die zweite Leiterbahn 25 eingebunden. Der Stecker 5 und der weitere Stecker 5' sind dabei elektrisch leitend miteinander verbunden.

Allerdings könnte grundsätzlich alternativ beispielsweise auch der zuerst genannte Stecker 5 über die Verbindungsmittel 3 permanent mit der zweiten Leiterbahn 25 der zweiten Platine 2 elektrisch verbunden sein.

Insbesondere kann also die Gestaltung derart sein, dass die LEDs 10 der ersten Platine 1 und die LEDs 20 der zweiten Platine 2 elektrisch in einer Reihe miteinander verbunden sind, wenn der Stecker 5 in die Buchse 4 eingesteckt ist bzw. gegebenenfalls auch der weitere Stecker 5' in die weitere Buchse 4' eingesteckt ist.

Beim gezeigten Beispiel ist durch die Verbindungsmittel 3 wie erwähnt eine gemeinsame Leiterbahn gebildet, die einerseits den ersten Ast 151 der ersten Leiterbahn 15 mit dem ersten Ast 251 der zweiten Leiterbahn 25 leitend verbindet und andererseits den zweiten Ast 252 der zweiten Leiterbahn 25 mit dem zweiten Ast 152 der ersten Leiterbahn. Die LEDs 10 der ersten Platine 1 sind daher in einer Reihe bzw. seriell mit den LEDs 20 der zweiten Platine 32 geschaltet, gleichzeitig ist allerdings auch über die zweiten Äste 252, 152 eine elektrische Verbindung für die Rückführung des Stromkreises zur Stromquelle realisiert.

Weiterhin umfassen die Verbindungsmittel 3 beim hier gezeigten Beispiel ein flexibles Kabel 31, durch das der Stecker 5 und der weitere Stecker 5' elektrisch miteinander verbunden sind. Dabei ist an einem Endbereich des Kabels 31 der Stecker 5 angeordnet und der weitere Stecker 5' ist vorzugsweise an dem hierzu gegenüberliegenden anderen Endbereich des Kabels 31 angeordnet. Durch diese Gestaltung mit einem flexiblen Kabel lässt sich die gemeinsame Leiterbahn herstellen, ohne dass hierfür eine bestimmte gegenseitige Positionierung der beiden Platinen 1, 2 erforderlich wäre. Es lassen sich mit den so gestalteten Verbindungsmitteln 3 sozusagen unterschiedliche Distanzen bzw. Winkel zwischen den beiden Platinen 1, 2 überwinden. Außerdem kann eine entsprechende Kabelverbindung sehr gut mögliche thermische Ausdehnungen der Platinen 1, 2 aufnehmen. Ein weiterer Vorteil besteht darin, dass durch die genannte Gestaltung ermöglicht ist, dass kein Bauteil über eine der beiden Platinen 1, 2 seitlich oder in Richtung der Längsachse L übersteht. Beispielsweise kann dies im Fall einer Platine erwünscht sein, die am Ende einer Reihe von entsprechenden Platinen zur Bildung eines Lichtbands angeordnet ist.

Am nicht gezeigten zweiten Endbereich der ersten Platine 1 kann die erste Leiterbahn 15 eine weitere Buchse aufweisen, die analog zu der zuerst genannten Buchse 4 gestaltet ist und die zur Anbindung an die Stromquelle, also beispielsweise an eine Konstantstrom-Quelle dient. Analog kann die zweite Platine 2 am nicht gezeigten zweiten Endbereich eine entsprechende weitere, analog gestaltete Buchse aufweisen. Auf diese Weise lässt sich erzielen, dass zum genannten Verbinden der ersten Platine 1 mit der zweiten Platine 2 lediglich der Stecker 5 in die Buchse 4 eingesteckt werden muss. Am zweiten Endbereich der zweiten Platine 2 ist keinerlei Eingriff in die zweite Leiterbahn 25 erforderlich, denn hier ist der Übergang zwischen dem ersten Ast 251 der zweite Leiterbahn 25 und dem zweiten Ast 252 der zweiten Leiterbahn 25 durch die dort befindliche Buchse leitend geschlossen.

Wenn eine (in den Figuren nicht gezeigte) entsprechende dritte Platine am zweiten Endbereich der zweiten Platine 2 angeschlossen werden soll, lässt sich diese in analoger Weise, also wiederum durch lediglich einen Einsteckvorgang unter Zuhilfenahme entsprechend analog gestalteter weiterer Verbindungsmittel erzielen, u.s.w.

Allgemeiner formuliert können die erfindungsgemäßen Verbindungsmittel dazu genutzt werden, einen Verbraucher in Form einer Leuchte in eine "große" Leiterbahn "einzuklinken", so dass der Verbraucher seriell in die große Leiterbahn geschaltet ist. Beispielsweise ist dies im Fall eines Lichtbandsystems sinnvoll, in dem die große Leiterbahn zur Stromversorgung der Leuchtmodule des Lichtbandsystems an bestimmten Stellen entsprechende Buchsen oder Stecker aufweist. An diesen Stellen lassen sich dann die Leuchtmodule beliebig anschließen, wobei eine Reihenschaltung der Leuchtmodule gebildet ist.

Wie weiterhin aus den Figuren 2 und 3 erkennbar, kann die erste Patine 1 eine Durchgangsöffnung 17 aufweisen, wobei die Gestaltung derart ist, dass ein entsprechend gestalteter (in den Figuren nicht gezeigter) Stecker die Durchgangsöffnung 17 durchsetzend angeordnet ist, wenn der Stecker in die Buchse 4 eingesteckt ist. Vorzugsweise ist dabei die Gestaltung derart, dass der Stecker wahlweise entweder von derjenigen Seite der Platine, auf der die Buchse 4 angeordnet ist, eingesteckt werden kann oder von der hierzu gegenüberliegenden Platinen-Seite. Wie aus den Figuren 2 und 3 weiterhin erkennbar, kann die Buchse 4 ein, insbesondere aus Kunststoff bestehendes Gehäuse 45 aufweisen. Hierdurch lässt sich die Kontaktstelle insbesondere berührungssicher gestalten.

Zur elektrischen Verbindung der zwei Kontaktelemente 41, 42 der Buchse 4 mit dem (restlichen) Leiterbereich der ersten Leiterbahn 15 können, wie in Fig. 2 angedeutet, Lötstellen 6 vorgesehen sein. Die weitere Buchse 4' ist vorzugsweise analog mit der zweiten Leiterbahn 25 verbunden.

Die Buchse 4 kann also lagefest an der ersten Platine 1 angeordnet sein. Alternativ kann jedoch die Buchse 4 beispielsweise über eine lösbare Steckverbindung an der ersten Platine 1 angeordnet sein. Auf diese Weise lässt sich erzielen, dass die Buchse 4 bei Bedarf einfach von der ersten Platine 1 separiert werden kann. Beispielsweise kann die Buchse 4 verschiebbar an der ersten Platine 1 angeordnet sein.

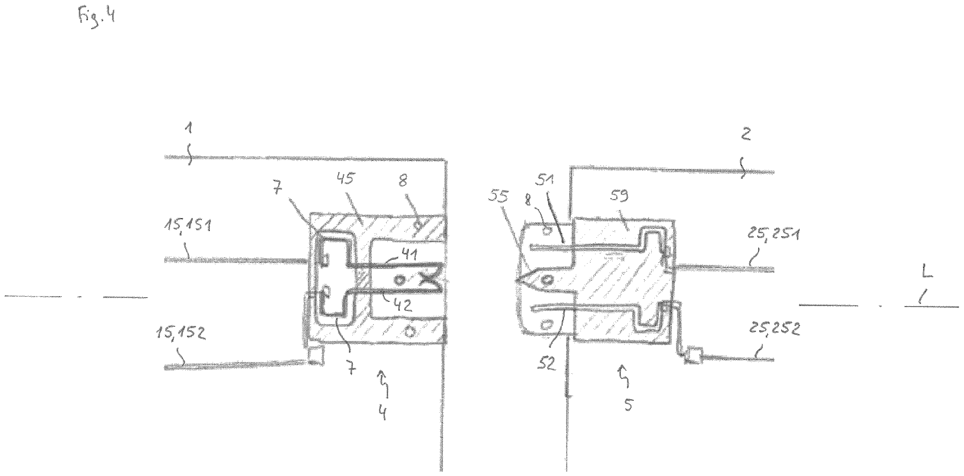

In Fig. 4 ist eine Skizze zu einem weiteren Ausführungsbeispiel eines erfindungsgemäßen Systems skizziert. Soweit nicht anders angegeben, gelten die obigen Ausführungen auch für dieses Beispiel; die Bezugszeichen sind analog gebraucht.

Bei diesem Beispiel weisen die Verbindungsmittel 3 kein flexibles Kabel auf, vielmehr sind sie im Wesentlichen "starr" ausgebildet. Durch die Verbindungsmittel 3 ist seitens ersten Platine 1 wiederum eine Art Buchse 4 gebildet und seitens der zweiten Platine 2 eine Art Stecker 5. Die Buchse 4 kann beispielswiese lagefest mit der ersten Platine 1 verbunden sein und der Stecker 5 kann lagefest mit der zweiten Platine 2 verbunden sein. Die beiden Platinen 1, 2 lassen sich bei dieser Ausführung durch die Verbindungsmittel 3 sozusagen ineinander stecken.

Weiterhin können die Verbindungsmittel 3 Rastelemente 8 aufweisen, die für eine rastende Verbindung zwischen der Buchse 4 und dem Stecker 5 ausgestaltet sind. Hierdurch lässt sich bewirken, dass die Kontaktflächen der Buchse 4 und des Steckers 5 nicht zueinander beweglich sind und somit durch - zum Beispiel thermisch bedingte - Längenänderungen aufeinander reiben, wodurch die Kontaktflächen beschädigt werden könnten. Die zwei Kontaktelemente 41, 42 der Buchse 4 weisen erfindungsgemäß jeweils eine entsprechend beweglich gestaltete Lasche 7 auf, die dafür vorgesehen ist, etwaige thermisch bedingte Längenänderungen aufzunehmen. Zusätzlich können auch die Kontaktelemente 51, 52 des Steckers 5 entsprechend gestaltete Laschen aufweisen.

Die Kontaktelemente 51, 52 des Steckers 5 können hier so gestaltet sein, dass sie nicht auf dem Trennelement 55 angeordnet sind, sondern von Letzterem separiert. Die Kontaktelemente 41, 42 der Buchse 4 werden beim Einstecken des Steckers 5 hierbei auseinander bewegt und berühren, wenn der Stecker 5 ganz eingesteckt ist, die Kontaktelemente 51, 52 des Steckers 5 entsprechend.

Der Stecker 5 kann so gestaltet sein, dass er in einer Richtung der Längsachse L über die zweite Platine 2 hinaus vorsteht bzw. übersteht. Wenn der Stecker 5 ganz eingesteckt ist, sind die beiden Platinen 1, 2 in bestimmter gegenseitiger Ausrichtung miteinander verbunden, im Fall von länglichen Platinen 1, 2 vorzugsweise so, dass sie jeweils entlang der Längsachse L ausgerichtet sind und dabei eine Reihe bilden.

Vorzugsweise weist die Buchse 4 ein entsprechendes Gehäuse 45 auf und auch der Stecker 5 ein Gehäuse 59, wobei sich die beiden Gehäuse 45, 59 im verbundenen Zustand um die Kontakte 41, 42, 51, 52 herum erstrecken. Hierdurch lässt sich die Verbindung besonders geeignet berührungssicher gestalten; insbesondere ist auf diese Weise geeignet eine Hochvoltschaltung ermöglicht.

Alternativ zu der lagefesten Anordnung der Buchse 4 an der ersten Platine 1 kann beispielsweise vorgesehen sein, dass die Buchse verschiebbar an der ersten Platine 1 angeordnet ist. Es kann auch vorgesehen sein, dass die Buchse 4 durch eine reversibel lösbare Steckverbindung mit der ersten Platine 1 verbunden ist.

Auch der Stecker 5 kann entweder lagefest an der zweiten Platine 2 angeordnet sein oder beispielsweise verschiebbar. Insbesondere kann der Stecker 5 durch eine reversibel lösbare Steckverbindung mit der zweiten Platine 2 verbunden sein. Dies kann beispielsweise für Lichtbandanwendungen erwünscht sein, um zu verhindern, dass der Stecker 5 stirnseitig über die zweite Platine 2 bzw. ein entsprechendes Leuchtmodul heraussteht.

Die Gestaltung kann beispielsweise derart sein, dass der Stecker 5 verschiebbar an der zweiten Platine 2 angeordnet ist. Hierbei erfolgt die Kontaktierung mit linearem Verschieben des Steckers 5, wobei die Kontaktelemente 51, 52 auf entsprechenden Platinen-Kontakten gleiten.

Im Folgenden sind noch weitere Merkmale angegeben, die sich grundsätzlich auf alle Ausführungsbeispiele beziehen.

Die erfindungsgemäßen Verbindungsmittel 3 eignen sich beispielswiese auch für die Einschaltung einer Stromquelle in eine Leiterbahn, wobei der "Verbraucher" durch die Stromquelle gebildet ist.

Die erfindungsgemäßen Verbindungsmittel können so gestaltet sein, dass die Buchse 4 und der Stecker 5 jeweils mehr als zwei Kontaktelemente aufweisen, so dass eine dreipolige oder vierpolige, allgemein eine n-polige Kontaktierung ermöglicht ist. Dies kann beispielsweise zur Übertragung von Steuersignalen vorteilhaft sein.

Es kann herstellungstechnisch vorteilhaft vorgesehen sein, dass die Buchse 4 als SMD Bauteil (SMD: surface-mounted device, oberflächenmontiertes Bauelement) auf der ersten Platine 1 angeordnet ist. Dabei kann die Buchse 4 auf derjenigen Platinen-Seite angeordnet sein, auf der sich die LEDs 10 befinden oder auf der hierzu gegenüberliegenden Platinen-Seite. Analoges gilt im Fall der weiteren Buchse 4' und der zweiten Platine 2.

Um eine dauerhafte Kontaktierung besonders zuverlässig zu erzielen, kann vorgesehen sein, dass auf die Kontaktelemente eine zusätzliche Federkraft wirkt, zum Beispiel durch ein Gehäuse oder ein zusätzliches Bauteil.

Es kann vorgesehen sein, dass im verbundenen Zustand bzw. bei eingestecktem Stecker 5 die Kontaktierung gesichert ist, so dass nicht allein die Dauerelastizität der Kontakte die Verbindung sichert. Hierdurch ist eine besonders geringe Baugröße ermöglicht, da die Federkontakte nicht im dauerelastischen Bereich liegen müssen.

Mit dem erfindungsgemäßen System lässt sich eine Reduktion der erforderlichen Bauteile bei insgesamt einfacher Ausgestaltung erzielen. Ein Einsatz eines Verdrahtungsroboters ist zur Herstellung nicht erforderlich.

Besonders vorteilhaft lässt sich das System als Teil einer Leuchte bzw. eines Leuchtensystems, insbesondere eines Lichtbands einsetzen. Das System ermöglicht hierbei eine deutliche Vereinfachung der Herstellung. Bei Lichtbandanwendungen können durch Aneinanderreihen mehrerer gleichartiger, jeweils gleichlanger Platinen unterschiedliche Leuchtenlängen herstellungstechnisch vorteilhaft erzielt werden.

## Patentansprüche

1. System mit elektrischen Einheiten, aufweisend
- eine erste Einheit mit einer ersten elektrischen Leiterbahn (15),
- eine zweite Einheit mit einem elektrischen Verbraucher und
- Verbindungsmittel (3) zum Anschließen des Verbrauchers an die erste Leiterbahn (15),
wobei die Verbindungsmittel (3) eine Buchse (4) mit zwei Kontaktelementen (41, 42) und einen, reversibel lösbar in die Buchse (4) einsteckbaren Stecker (5) mit zwei Kontaktelementen (51, 52) aufweisen,
wobei die erste Einheit eine erste Platine (1) mit LEDs (10) aufweist, die in die erste Leiterbahn (15) geschaltet sind und
die zweite Einheit eine zweite elektrische Leiterbahn (25) aufweist, sowie eine zweite Platine (2) mit LEDs (20), die in die zweite Leiterbahn (25) geschaltet sind,
wobei der Verbraucher durch die LEDs (20) der zweiten Platine (1) gegeben ist, wobei die Verbindungsmittel (3) derart ausgestaltet sind, dass bei einem Einstecken des Steckers (5) in die Buchse (4) die erste Leiterbahn (15) unterbrochen wird und der Verbraucher an die beiden, durch diese Unterbrechung gebildeten Endstücke der ersten Leiterbahn (15) elektrisch angeschlossen wird,
wobei der Stecker (5) ein keilförmiges Trennelement (55) aufweist, das die zwei Kontaktelemente (41, 42) der Buchse (4) elektrisch voneinander trennend angeordnet ist, wenn der Stecker (5) in die Buchse (4) eingesteckt ist,
**dadurch gekennzeichnet,**
**dass** die zwei Kontaktelemente (41, 42) der Buchse (4) jeweils eine beweglich gestaltete Lasche (7) aufweisen, die dafür vorgesehen ist, etwaige thermisch bedingte Längenänderungen aufzunehmen.

2. System nach Anspruch 1,
bei dem der Verbraucher durch eine LED-Lichtquelle gebildet ist.

3. System nach Anspruch 1 oder 2,
bei dem die LEDs (10) der ersten Patine (1) durch die erste Leiterbahn (15) in Reihe geschaltet miteinander verbunden sind und die LEDs (20) der zweiten Platine (2) durch die zweite Leiterbahn (25) in Reihe geschaltet miteinander verbunden sind,
wobei die Gestaltung derart ist, dass die LEDs (10) der ersten Platine (1) und die LEDs (20) der zweiten Platine (2) elektrisch in einer Reihe miteinander verbunden sind, wenn der Stecker (5) in die Buchse (4) eingesteckt ist.

4. System nach einem der vorhergehenden Ansprüche,
bei dem die Buchse (4) durch eine reversibel lösbare Steckverbindung mit der ersten Platine (1) verbunden ist.

5. System nach einem der vorhergehenden Ansprüche,
bei dem die erste Patine (1) eine Durchgangsöffnung (17) aufweist und die Gestaltung derart ist, dass der Stecker die Durchgangsöffnung (17) durchsetzend angeordnet ist, wenn der Stecker in die Buchse (4) eingesteckt ist.

6. System nach einem der vorhergehenden Ansprüche,
bei dem der Stecker (5) an der zweiten Platine (2) angeordnet ist, vorzugsweise lagefest oder verschiebbar an der zweiten Platine (2) angeordnet ist, wobei insbesondere der Stecker (5) durch eine reversibel lösbare Steckverbindung mit der zweiten Platine (2) verbunden ist.

## Claims

1. A system with electrical units, having
- a first unit with a first electrical conductor track (15),
- a second unit with an electrical load and
- connecting means (3) for connecting the load to the first conductor track (15),
wherein the connecting means (3) have a socket (4) with two contact elements (41, 42) and a plug (5) with two contact elements (51, 52), which plug can be plugged reversibly detachably into the socket (4),
wherein the first unit has a first circuit board (1) with LEDs (10), which are connected in the first conductor track (15) and
the second unit has a second electrical conductor track (25), as well as a second circuit board (2) with LEDs (20), which are connected in the second conductor track (25),
wherein the load is given by the LEDs (20) of the second circuit board (1),
wherein the connecting means (3) are designed in such a manner that when the plug (5) is plugged into the socket (4) the first conductor track (15) is interrupted and the load is electrically connected to the two end pieces of the first conductor track (15) formed by this interruption,
wherein the plug (5) has a wedge-shaped separating element (55), which is arranged separating the two contact elements (41, 42) of the socket (4) electrically from one another, if the plug (5) is plugged into the socket (4),
**characterized in**
**that** the two contact elements (41, 42) of the socket (4) in each case have a movably designed flap (7), which is provided to accommodate any thermally induced changes in length.

2. A system according to Claim 1,
in which the load is formed by an LED light source.

3. A system according to Claim 1 or 2,
in which the LEDs (10) of the first circuit board (1) are connected in series with each other through the first conductor tract (15) and the LEDs (20) of the second circuit board (2) are connected in series with each other through the second conductor tract (25),
wherein the design is such that the LEDs (10) of the first circuit board (1) and the LEDs (20) of the second circuit board (2) are connected electrically with each other in series, if the plug (5) is plugged into the socket (4).

4. A system according to any one of the preceding claims,
in which the socket (4) is connected through a reversibly detachable plug connection with the first circuit board (1).

5. A system according to any one of the preceding claims,
in which the first circuit board (1) has a through-opening (17) and the design is such that the plug is arranged through the through-opening (17), if the plug is plugged into the socket (4).

6. A system according to any one of the preceding claims,
in which the plug (5) is arranged on the second circuit board (2), preferably is arranged in a positionally fixed manner or displaceably on the second circuit board (2), wherein in particular the plug (5) is connected with the second circuit board (2) through a reversibly detachable plug connection.

## Revendications

1. Système avec des unités électriques, comprenant
- une première unité avec une première piste électro-conductrice (15),
- une deuxième unité avec un consommateur électrique et
- des moyens de liaison (3) pour le raccordement du consommateur à la première piste électro-conductrice (15),
les moyens de liaison (3) comprenant une douille (4) avec deux éléments de contact (41, 42) et un connecteur (5) pouvant être inséré de manière amovible et réversible dans la douille (4), avec deux éléments de contact (51, 52),
la première unité comprenant une première platine (1) avec des LED (10), qui sont branchées dans la première piste électro-conductrice (15) et
la deuxième unité comprenant une deuxième piste électro-conductrice (25) ainsi qu'une deuxième platine (2) avec des LED (20), qui sont branchées dans la deuxième piste électro-conductrice (25),
le consommateur étant constitué des LED (20) de la deuxième platine (1),
les moyens de liaison (3) étant conçus de façon à ce que, lors d'une insertion du connecteur (5) dans la douille (4), la première piste électro-conductrice (15) soit interrompue et le consommateur soit raccordé électriquement aux deux embouts, formés par cette interruption, de la première piste conductrice (15),
le connecteur (5) comprenant un élément de séparation cunéiforme (55) qui est disposé de façon à séparer électriquement les deux contacts (41, 42) de la douille (5) entre eux lorsque le connecteur (5) est inséré dans la douille (4),
**caractérisé en ce que**
les deux éléments de contact (41, 42)de la douille (4) comprennent chacun une patte mobile (7) qui est prévue afin de compenser d'éventuelles variations de longueur dues à une dilatation thermique.

2. Système selon la revendication 1,
dans lequel le consommateur est constitué d'une source de lumière LED.

3. Système selon la revendication 1 ou 2,
dans lequel les LED (10) de la première platine (1) sont branchées entre elles en série par la première piste conductrice (15) et les LED (20) de la deuxième platine (2) sont branchées entre elles en série par la deuxième piste conductrice (25),
la conception étant telle que les LED (10) de la première platine (1) et les LED (20) de la deuxième platine (2) soient reliées électriquement entre elles en série lorsque le connecteur (5) est inséré dans la douille (4).

4. Système selon l'une des revendications précédentes,
dans lequel la douille (4) est reliée par une liaison d'enfichage réversible avec la première platine (1).

5. Système selon l'une des revendications précédentes,
dans lequel la première platine (1) comprend une ouverture de passage (17) et la conception est telle que le connecteur est disposé de façon à traverse l'ouverture de passage (17) lorsque le connecteur est inséré dans la douille (4).

6. Système selon l'une des revendications précédentes,
dans lequel le connecteur (5) est disposé sur la deuxième platine (2), de préférence de manière fixe ou coulissante sur la deuxième platine (2), plus particulièrement le connecteur (5) étant relié par une liaison d'enfichage réversible avec la deuxième platine (2).
